**Europäisches Patentamt**

**European Patent Office**

**Office européen des brevets**

(19)

(11) Veröffentlichungsnummer: **0 253 215 B1**

# (12) EUROPÄISCHE PATENTSCHRIFT

(45) Veröffentlichungstag der Patentschrift:
02.01.91 Patentblatt 91/01

(51) Int. Cl.$^5$: **G11B 20/10**, G01R 29/027,
// H04L25/49

(21) Anmeldenummer: 87109510.5

(22) Anmeldetag: 02.07.87

(54) Verfahren und Vorrichtung zur Verarbeitung von Impulsen eines Signals, das durch vorausgehende Uebertragung verzerrt ist.

(30) Priorität: 10.07.86 CH 2772/86

(43) Veröffentlichungstag der Anmeldung:
20.01.88 Patentblatt 88/03

(45) Bekanntmachung des Hinweises auf die
Patenterteilung:
02.01.91 Patentblatt 91/01

(84) Benannte Vertragsstaaten:
CH DE FR GB IT LI

(56) Entgegenhaltungen:
DE-A- 2 311 386
DE-A- 3 140 432
US-A- 3 956 616

(56) Entgegenhaltungen:
IBM TECHNICAL DISCLOSURE BULLETIN,
Band 9, Nr. 7, Dezember 1966, Seiten 793-795,
New York, US; A.J. FOLMAR et al.:
"Pulse-width code detection and
comparison"
RADIO FERNSEHEN ELEKTRONIK, Band 32,
Nr. 8, August 1983, Seiten 539-540, Ost-Berlin,
DE: "Impuls-Zähl und Sortierschaltung"
ELECTRONICS INTERNATIONAL, Band 55, Nr.
5, März 1982, Seiten 139-141, New York, US; Y.
JOSEFSBERG: "Stable and fast PLL switches
loop bandwidths"
INSTRUMENTS AND EXPERIMENTAL
TECHNIQUES, Band 23, Nr. 3, Teil 1, Mai-Juni
1980, Seiten 650-652, Plenum Publishing
Corp., New York, US; V.V. BLATOV et al.:
"Pulse duration selector"

(73) Patentinhaber: WILLI STUDER AG Fabrik für
elektronische Apparate
Althardstrasse 30
CH-8105 Regensdorf ZH (CH)

(72) Erfinder: Piot, Julien
198 Allston Street
Cambridge, 02139 Mass. (US)

EP 0 253 215 B1

## Beschreibung

Die Erfindung betrifft ein Verfahren und eine Vorrichtung zur Verarbeitung von Impulsen eines Signales, das durch vorausgehende Uebertragung verzerrt ist, wobei Lauflaengen der einzelnen Impulse gemessen werden, mehrere Schwellwerte fuer die Lauflaengen vorgegeben werden, wobei die Schwellwerte Lauflaengenbereiche definieren, die Klassen fuer die gemessenen Lauflaengen bilden und die Klassen die urspruengliche Lauflaenge der unverzerrten Impulse angeben.

Ein Verfahren und eine Vorrichtung aehnlicher Art ist aus "RADIO FERNSEHEN ELEKTRONIK" Band 32, Nr. 8, August 1983, Seiten 539 bis 540, Ost-Berlin, bekannt. Die beschriebene Impuls- Zaehl- und Sortierschaltung ist in der Lage Impulse in einer Folge zu zaehlen und sie nach ihrer Dauer in vorher bestimmbare Klassen zu sortieren.

Bei dieser Schaltung werden die Klassen einmal festgelegt und fuer immer so beibehalten. Eine Anpassung an die Art der Verzerrung die die eintreffenden Impulse erfahren haben, findet nachtraeglich nicht mehr statt. Damit sind ausserordentlich hohe Anforderungen bezueglich geschickter Definition der einzelnen Klassen gestellt, die schwer zu erfuellen sind.

Aus der europaeischen Patentanmeldung Nr 0 148 413 ist weiter ein Verfahren und eine Vorrichtung bekannt, mit der Fehler in Signalen, die in der Form von Impulsen beispielsweise mit einem magnetischen Aufzeichnungstraeger uebertragen werden, korrigiert werden koennen. Dabei werden insbesodere die Lauflaengen, die diese Impulse zwischen aufeinanderfolgenden Impulsflanken aufweisen korrigiert. Dazu werden zuerst Signalabweichungen zu den Lauflaengen ermittelt und gespeichert, dann wird eine direkte Verarbeitung der Eingangssignale zu Ausgangssignalen durchgefuehrt, indem Signalabweichungen mit den Eingangssignalen bzw. deren Lauflaengen kombiniert werden, so dass Ausgangssignale entstehen.

Aus der europaeischen Patentanmeldung Nr 0 147 550 ist auch eine Schaltung zur Verarbeitung und insbesondere zur Umformung von Impulsen bekannt. Damit koennen verformte Impulse oder verzerrte Impulse so veraendert werden, dass sie der ihnen urspruenglich zugedachten Form, beispielsweise nach einer Aufzeichnung auf einem Magnetband, besser entsprechen. In dieser Schaltung wird der zeitliche Abstand je zweier aufeinanderfolgender Impulse, die die Daten darstellen, erfasst und gemessen. Dieser zeitliche Abstand gibt einen Hinweis auf die Groesse der Verzerrung der Impulse. Aufgrund dieser Messung wird ein Korrektursignal erzeugt, gemaess welchem die eintreffenden Impulse verformt werden.

Waehrend die Schaltung gemaess der Patentanmeldung Nr 0 148 413 zuerst vorbereitet werden muss, indem Speicher mit den Signalabweichungen aufgefuellt werden, kann die Schaltung gemaess Patentanmeldung Nr 0 147 550 ohne Vorbereitung sofort zum Einsatz gelangen, denn sie passt sich laufend an die eintreffenden Signale an.

Der Nachteil der Schaltung gemaess der europaeischen Patentanmeldung 0 147 550 besteht darin, dass das analoge Eingangssignal auch auf analoge Art und Weise veraendert wird. Es wird damit versucht, das analoge Eingangssignal dem idealen und urspruenglichen analogen Signal anzupassen, was nur in dem Masse gelingen kann, als ein mehr oder weniger verstaerktes Korrektursignal dem Eingangssignal zugefuegt wird. Genuegt dies nicht, so sind die Moeglichkeiten dieser Schaltung ausgeschoepft.

Der Nachteil der Schaltung gemaess der europaeischen Patentanmeldung 0 148 413 besteht darin, dass die Korrektur der ermittelten Lauflaengen nicht adaptiv erfolgt, d.h. die Korrektur passt sich nicht laufend an die Signale an.

Die Erfindung wie sie in den unabhängigen Anspruechen 1 und 8 gekennzeichnet ist, loest die Aufgabe ein Verfahren und eine Vorrichtung zu schaffen, mit denen die wirklichen oder urspruenglichen Lauflaengen der Impulse eines Signales adaptiv ermittelt werden koennen.

Die durch die Erfindung erreichten Vorteile sind insbesondere darin zu sehen, dass dadurch unmittelbar fuer die nachfolgende digitale Verarbeitung geeignete Signale erzeugt werden koennen. Es koennen demnach auch schnell arbeitende Bauelemente fuer die digitale Signalverarbeitung eingesetzt werden. Ferner kann sich die erfindungsgemaesse Vorrichtung selbsttaetig auf veraenderte Parameter einstellen. Die Information, die von einem Signal getragen wird, kann auch dann noch gelesen werden, wenn das Signal analog nicht vollstaendig entzerrt werden kann. Bei der Verarbeitung von Impulsen, die durch vorausgehende Aufzeichnung auf einem magnetischen Aufzeichnungstraeger verzerrt wurden, ist die erfindungsgemaesse Art der adaptiven Verarbeitung besonders vorteilhaft, weil die dabei verwendeten Aufnahme-und Wiedergabekoepfe nicht immer eine identische Charakteristik aufweisen. Ferner kann auch der verwendete Aufzeichnungstraeger abweichende Charakteristiken aufweisen. Ebenso kann die Bandgeschwindigkeit und der Aufnahmestrom variieren. Die Auswirkungen aller dieser unerwuenschten Abweichungen koennen durch die vorgeschlagene Verarbeitung ihre negative Wirkung nicht entfalten. Dies auch dann nicht, wenn diese Abweichungen sich langzeitlich aendern.

Im folgenden wird die Erfindung anhand von lediglich einen Ausfuehrungsweg darstellenden Zeichnungen naeher erlaeutert. Es zeigt :

Figur 1, a bis d verschiedene Formen digitaler Signale,

Figur 2, a bis c Haeufigkeitsverteilungen und Schwellwerte fuer ein Signal,

Figur 3 eine Besonderheit im Zusammenhang mit einer Haeufigkeitsverteilung,

Figur 4 ein Blockschema einer erfindungsgemaessen Vorrichtung,

Figuren 5 und 6 eine genauere Darstellung der Vorrichtung gemaess Figur 4,

Figur 7 ein Blockschema einer weiteren Ausfuehrung der erfindungsgemaessen Vorrichtung,

Figuren 8, 9 und 10 je eine Ausfuehrung eines Teils der Vorrichtung gemaess Figur 7 und

Figur 11 eine Charakteristik fuer einen Teil gemaess Figur 8 und 10.

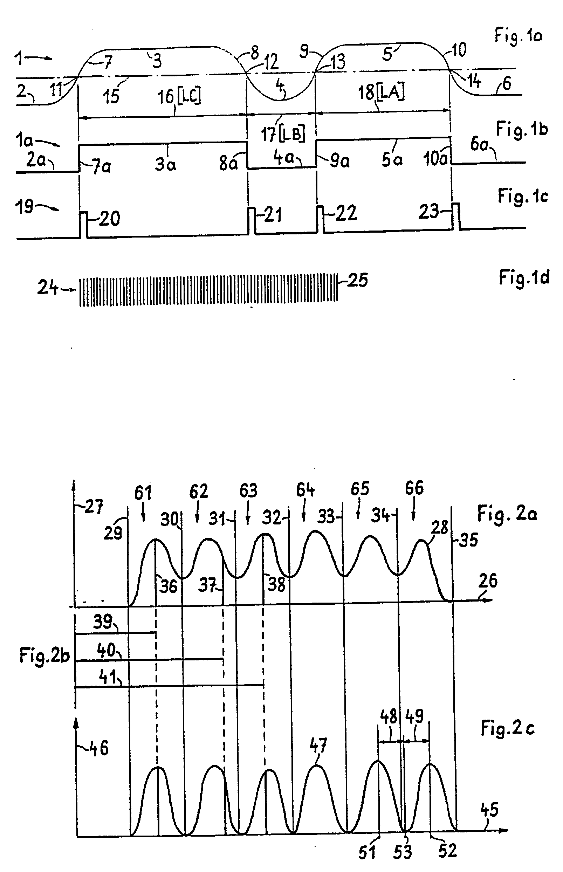

Figur 1a zeigt ein Signal 1, das aus einer Folge von positiven und negativen Impulsen 2, 3, 4, 5 und 6 zusammengesetzt ist. Diese Impulse 2 bis 6 werden durch Impulsflanken 7, 8, 9 und 10 untereinander abgegrenzt. Durchgangspunkte 11, 12, 13 und 14 dieser Impulsflanken 7 bis 10 durch eine Nulllinie 15 definieren Lauflaengen 16, 17 und 18 der Impulse 3, 4 und 5.

Figur 1b zeigt das Signal 1a mit Impulsen 2a, 3a, 4a, 5a und 6a, die die Impulse 2 bis 6 des Signales 1 in idealer Form mit unendlich steilen Impulsflanken 7a bis 10a darstellen.

Figur 1c zeigt ein Signal 19, das nur aus kurzen positiven Impulsen 20, 21, 22 und 23 besteht, die den Beginn einer neuen Lauflaenge anzeigen.

Figur 1d zeigt ein Taktsignal 24, mit Impulsen 25, mit denen beispielsweise die Lauflaengen 16 bis 18 gemessen werden koennen.

Figur 2a zeigt eine Haeufigkeitsverteilung von gemessenen Lauflaengen. Auf der horizontalen Achse 26 sind Werte fuer die Lauflaengen aufgetragen. Auf der vertikalen Achse 27 sind Werte fuer die Haeufigkeit, mit der bestimmte Lauflaengen in einem Signal ueber laengere Zeit betrachtet auftreten, aufgetragen. Die Haeufigkeitsverteilung wird durch eine Linie 28 dargestellt. Vertikale Linien 29 bis 35 geben Schwellwerte fuer die Lauflaengen an. Man erkennt, dass die Haufigkeit von Lauflaengen im Beriche der Schwellwerte relativ gering, zwischen den Schwellwerten aber wesentlich hoeher ist. Gemessene Haeufigkeiten fuer einzelne Lauflaengen sind mit 36, 37 und 38 bezeichnet. Die Schwellwerte teilen das Gebiet der moeglichen Lauflaengen in Klassen oder Lauflaengenbereiche 61 bis 66 auf. Lauflaengen in einer Klasse weisen urspruenglich oder idealerweise dieselbe Lauflaenge auf.

Figur 2b zeigt fuer die gemessenen Haeufigkeiten 36, 37 und 38 gemaess Figur 2a die entsprechenden Lauflaengen 39, 40 und 41.

Figur 2c zeigt wiederum eine horizontale Achse 45 mit Werten fuer Lauflaengen sowie eine vertikale Achse 46 mit Werten fuer die Haeufigkeit des Auftretens einzelner Lauflaengen in einem Signal. Die Haeufigkeitsverteilung ist durch eine Linie 47 dargestellt. Sie ist unter der Voraussetzung gemessen worden, dass die gemessenen Lauflaengen immer von einer vorausgehenden Lauflaenge mit dem gleichen Wert (oder Laenge) und von einer nachfolgenden Lauflaenge mit einem anderen aber immer gleichen Wert eingerahmt ist. Mit 51 ist die Lauflaenge bezeichnet, die zwischen den Schwellwerten 33 und 34 am haeufigsten auftritt. Mit 52 ist die Lauflaenge bezeichnet, die zwischen den Schwellwerten 34 und 35 am haeufigsten auftritt. Mit 53 ist ein neuer Schwellwert bezeichnet, der aus den haeufigsten Lauflaengen 51 und 52 abgeleitet ist. Er weist gleiche Abstaende 48 und 49 zu den haeufigsten Lauflaengen 51 und 52 auf. Im Vergleich zur Figur 2a erkennt man, dass fuer die Haeufigkeitsverteilung 47 wegen den veraenderten Randbedingungen, im Bereiche der Schwellwerte fast keine Lauflaengen gemessen werden.

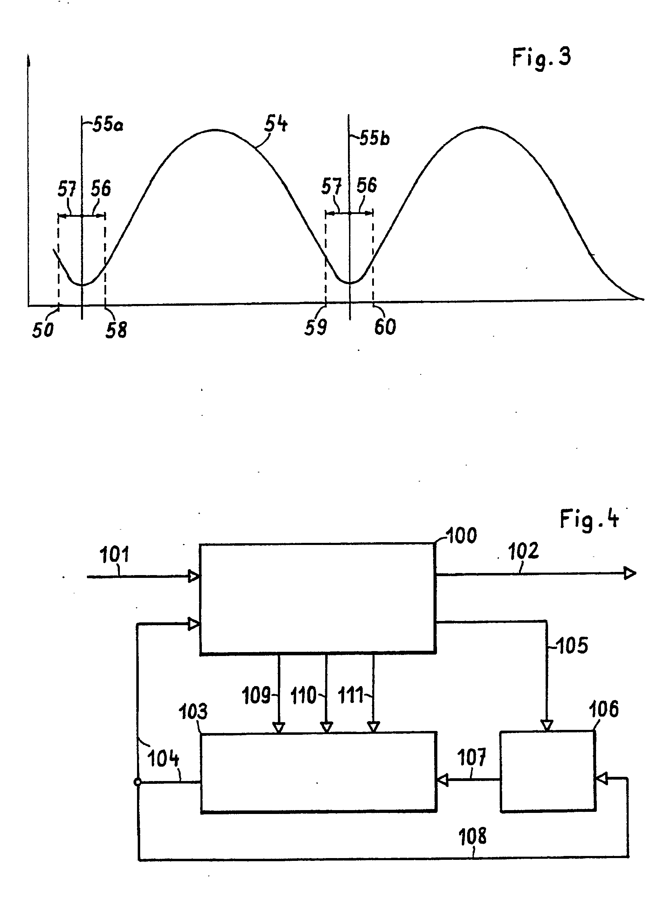

Figur 3 zeigt wiederum eine Haeufigkeitsverteilung, wie sie durch eine Kurve 54 dargestellt ist. Schwellwerte 55a und 55b sind dabei so bestimmt, dass davon ausgehend je ein positiver Abstand 56 und ein negativer Abstand 57 vorgesehen werden koennen, welche Lauflaengen 50, 58 und 59, 60 ergeben, die vorzugsweise mit je gleicher Haeufigkeit auftreten.

Figur 4 zeigt eine Lauflaengenverarbeitungseinheit 100, die in der Lage ist, ueber eine Leitung 101 eintreffende Impulse eines beispielsweise elektrischen Signales in eine Folge von Lauflaengen umzuwandeln, die ueber einen Bus 102 austreten und die als Folge von Zahlen erscheint, von denen jede Zahl eine Lauflaenge ausdrueckt. Die Lauflaengenverarbeitungseinheit 100 klassiert die eintreffenden Impulse gemaess ihren Lauflaengen mit Hilfe von Schwellwerten. Die Schwellwerte sind in einem Schwellwertspeicher 103 gespeichert und koennen ueber einen Bus 104 der Lauflaengenverarbeitungseinheit 100 fuer die Verarbeitung der Lauflaengen zur Verfuegung gestellt werden. Die gemessenen und mit den Schwellwerten klassierten Lauflaengen der Impulse werden zudem ueber einen Bus 105 einer Statistik-Auswertungseinheit 106 zugefuehrt. Mit Hilfe einer darin erstellten Statistik ueber die Haeufigkeit der einzelnen gemessenen Lauflaengen, passt diese laufend die Schwellwerte im Schwellwertspeicher 103 so an, dass die Schwellwerte fuer die groesstmoegliche Zahl der gemessenen Lauflaengen eine eindeutige Klassierung ermoeglichen. Deshalb ist ein Bus 107 zwischen dem Schwellwertspeicher 103 und der Auswertungseinheit 106 vorgesehen. Ueber einen Bus 108 werden die ausgegebenen Schwellwerte auch der Auswertungseinheit 106 zugefuehrt. Ueber Busse 109, 110 und 111 werden die aktuelle Lauflaenge wie auch die der aktuellen Lauflaenge vorausgehende Lauflaenge und die nachfolgende Lauflaenge dem Schwellwertspeicher 103 uebermittelt, was erlaubt, Schwellwerte fuer eine gemessene Lauflaenge auch in Funktion der umgebenden Lauflaengen auszugeben. Die Wirkungsweise der Vorrichtung gemaess Figur 4 kann anhand der nachfolgend beschriebenen Figuren besser verstanden werden.

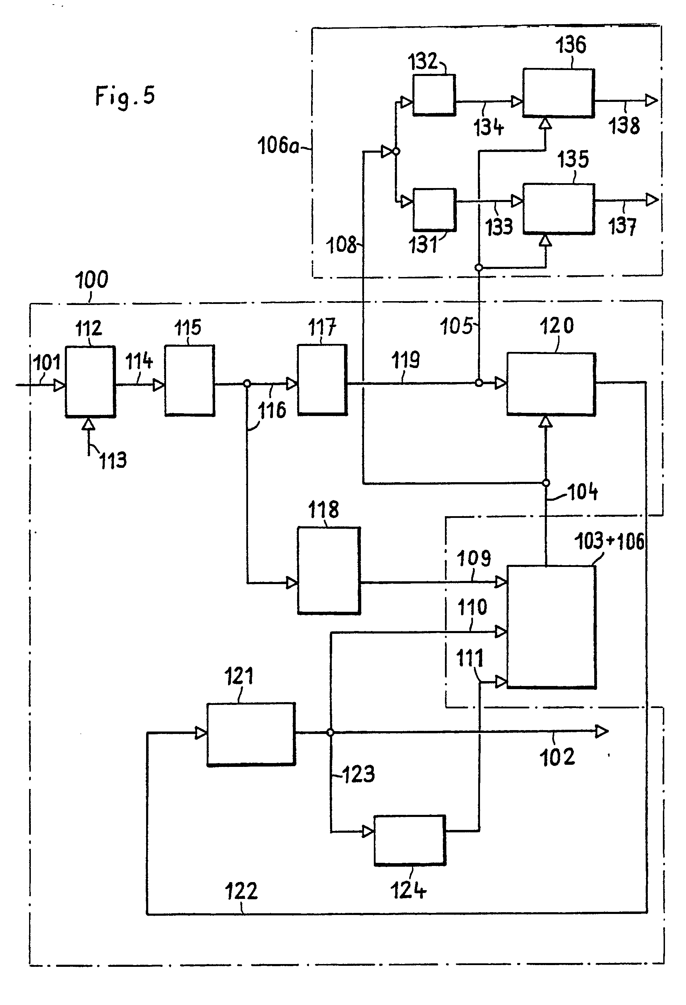

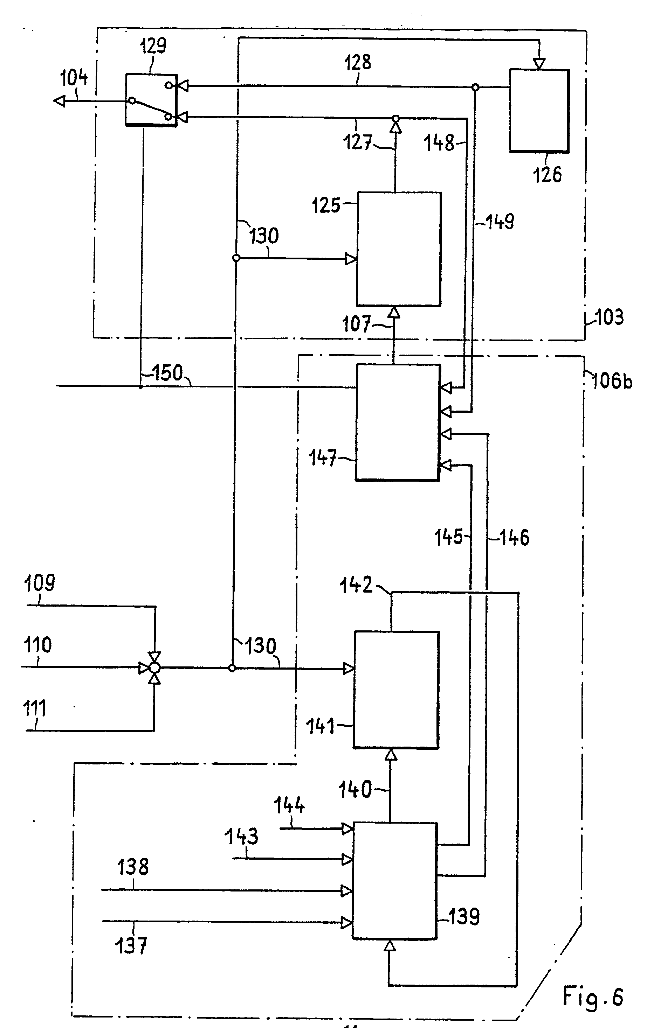

Figur 5 und Figur 6 zeigen zusammen ein Ausfuehrungsbeispiel der erfindungsgemaessen Vorrichtung gemaess Figur 4. Dabei sind jene Elemente, die bereits in der Figur 4 erscheinen mit denselben Bezugszeichen versehen. Man beachte insbesondere, dass der Schwellwertgenerator 103 + 106 aus Figur 5, den Schwellwertspeicher 103 und die Statistik-Auswertungseinheit 106 gemaess Figur 4 umfasst. Diese wiederum besteht aus zwei Teilen 106a und 106b, von denen einer in der Figur 5 und der andere in der Figur 6 erscheint. Es handelt sich dabei um vereinfachte schematische Darstellungen, bei denen beispielsweise keine Vorrichtungen fuer die zeitliche Steuerung der Vorgaenge dargestellt sind. Solche Vorrichtungen koennen von dem geeigneten Fachmann aber ohne Muehe aufgrung der nachfolgend gemachten Angaben ueber den zeitlichen Ablauf dieser Vorgaenge erstellt werden.

Zunaechst sei definiert, was in der nachfolgenden Beschreibung unter den Begriffen "Schwellwert" und "Lauflaenge" zu verstehen ist. Lauflaengen sind Abstaende zwischen aufeinanderfolgenden Flanken eines Impulses in einem Signal. Sie koennen in diesem Beispiel Werte zwischen "3" und "9" aufweisen und zwar mit sehr feiner Abstufung. Die Lauflaengen sollen durch Schwellwerte in Klassen oder Lauflaengenbereiche eingeteilt werden. Solche Schwellwerte sind in unserem Falle die Werte "3, 4, 5, 6, 7, 8 und 9". Die Lauflaengen sind nach dem naechst kleineren Schwellwert benannt. Somit werden beispielsweise Lauflaengen in einer Klasse mit Werten zwischen "4" und "5" als Lauflaenge "4" bezeichnet usw. Dieser Uebereinkunft liegt die Annahme zugrunde, dass das Signal urspruenglich oder idealerweise nur Lauflaengen mit den Werten "3.5, 4.5, 5.5, 6.5, 7.5, 8.5 und 9.5" aufwies. Die um diese Werte streuenden Lauflaengen seien nun beispielsweise in erster Naeherung durch Schwellwerte "4, 5, 6, 7, 8 und 9" gegeneinander abgegrenzt und eben als Lauflaengen "3, 4, 5, 6, 7, 8 und 9" bezeichnet.

Ueber Leitung 101 in Figur 5 trifft das zu verarbeitende Signal ein. Es besteht aus einer Folge von Impulsen, wie sie in der Figur 1a gezeigt sind und die durch Flanken abgetrennt, ineinander uebergehen wie das fuer digitale Signale bekannt ist. Das zu verarbeitende Signal kann aber auch zu einem Signal gemaess einer der Figuren 1b oder 1c umgewandelt auftreten. In einem Zaehler 112, der ein hochfrequentes Taktsignal gemaess Figur 1d ueber eine Leitung 113 erhaelt, wird damit die Laenge der Impulse zwischen den Flanken gemessen. Diese wird als Lauflaenge des Impulses bezeichnet. Ueber einen Bus 114 wird die gemessene Lauflaenge einem Speicher 115 oder Register zugefuehrt, der diese solange speichert, bis eine neue Lauflaenge gezaehlt ist. Die Lauflaengen sind nun durch eine Zahl ausgedrueckt, welche beispielsweise mit einem 7-Bit-Wort parallel weitergeleitet wird. Ein Bus 116 verbindet den Speicher 115 mit einem weiteren Speicher oder Register 117 und einem Lauflaengengenerator 118, welche beide parellel geschaltet sind.

Verfolgen wir nun, was mit drei aufeinanderfolgenden Lauflaengen LA, LB und LC geschieht. Von diesen tritt LC zuletzt auf und wird im Speicher 117 und im Lauflaengengenerator 118 eingelesen. Der Speicher 117 verzoegert jede Lauflaenge um die Zeit einer Lauflaenge. Wenn LC dort eintrifft, wird LB somit ausgelesen und ueber einen Bus 119 einem Vergleicher 120 zugefuehrt. Der Lauflaengengenerator 118, der beispielsweise als ROM ausgebildet ist, trifft eine erste grobe Entscheidung. Diese besteht darin, dass er den Wert von LC mit Werten der in ihm gespeicherten Tabellen vergleicht und LC eine der Lauflaengen "3, 4, 5, 6, 7, 8 oder 9" zuordnet. Dazu braucht es nur ein 3-Bit-Wort, das an einen Bus 109 abgegeben wird.

Die Lauflaenge LA, die zuerst in dieser Lauflaengenverarbeitungseinheit 100 behandelt wurde, befindet sich zu dieser Zeit im Bus 111 und ist somit an den Schwellwertgenerator 103+106 angelegt. Die Lauflaenge LC ist, wenn auch nur mit einem Naeherungswert, im Bus 109 ebenfalls dort angelegt. Zu bestimmen ist nun die Lauflaenge LB. Da aufeinanderfolgende Lauflaengen einander beeinflussen, sind im Schwellwertgenerator 103+106 mehrere Folgen von Schwellwerten gespeichert. Jede dieser Folgen ist fuer eine bestimmte Kombination von, der zu messenden Lauflaenge vorausgehenden und nachfolgenden Lauflaengen bestimmt. Da nun die vorausgehende Lauflaenge LA und die nachfolgende Lauflaenge LC bekannt sind, kann der Schwellwertgenerator 103+106 die geeignete Folge von Schwellwerten ermitteln und diese je nach dem eingegebenen vorlaeufigen Wert fuer LB (der wie nachfolgend beschrieben erzeugt wird) ueber den Bus 104 an den Vergleicher 120 abgeben, wo gerade die Lauflaenge LB angelegt ist.

Dem Schwellwertgenerator 103+106 ueber den Bus 110 vorgeschaltet, ist ein Hypothesengenerator 121, welcher wiederum ueber einen Bus 122 mit dem Vergleicher 120 verbunden ist. Der Hypothesengenerator 121 gibt ueber den Bus 110 angenommene vorlaeufige Werte fuer die zu bestimmende Lauflaenge LB ab, was den Schwellwertgenerator 103+106 jeweils dazu veranlasst, einen entsprechenden Schwellwert an den Vergleicher 120 abzugeben. Der Hypothesengenerator 121 ist beispielsweise als Sequenzer ausgebildet, der durch eine neueintreffende aktuelle Lauflaenge aktiviert wird und arbeitet nach dem Prinzip der sukzessiven Approximation. Das bedeutet, dass er zuerst einen mittleren Wert fuer eine Lauflaenge ausgibt, z.B. den Wert "6". Somit gibt der Schwellwertgenerator 103+106 als Schwellwert die "6" ueber den Bus 104 heraus. Der Vergleicher 120 stellt fest ob der gemessene Wert der Lauflaenge LB groesser oder kleiner als "6" ist. Diese Feststellung wird dem Hypothesengenerator 121 ueber den Bus 122 mitgeteilt und er trifft eine neue Wahl. Hat der Vergleich ergeben, dass z.B. der neue Schwellwert kleiner ist als "6", so waehlt der Hypothesengenerator 121 als neue vorlaeufige Lauflaenge die "4". Das veranlasst wiederum auf bekannte Weise den Schwellwertgenerator 103+106 als neuen Schwellwert die "4" an den Vergleicher 120 abzugeben. Dort wird beispielsweise festgestellt, dass LB groesser ist als "4". Somit waehlt nun der Hypothesengenerator 121 als letzten Schwellwert die "5" und der Vergleicher 120 stellt beispielsweise fest, dass LB kleiner ist. Dies wird wieder dem Hypothesengenerator 121 gemeldet und der schliesst nun aus dem Geschehen, dass die Lauflaenge LB einen Wert zwischen "4" und "5" hat und somit als "4" bezeichnet wird. Dieser wird einerseits ueber einen Bus 123 an ein Register 124 und andererseits ueber den Bus 102 als Resultat zur Weiterverarbeitung abgegeben. Das Register 124 verzoegert den Wert von LB um die Zeit einer Lauflaenge und gibt ihn dann an den Bus 111 ab. Dabei wird aus LB nun LA die aelteste Lauflaenge.

Ein erster Zyklus, der der Ermittlung einer Lauflaenge dient, ist somit abgeschlossen. Es folgt ein zweiter Zyklus, in dem die Schwellwerte an die bisher gemessenen Lauflaengen besser angepasst werden.

Die Schwellwerte sind im Schwellwertspeicher 103 (Fig. 4, 6) gespeichert. Dieser besteht aus einem RAM-Speicher 125 mit Werten die laufend angepasst werden, sowie aus einem ROM-Speicher 126 mit fest vorgegebenen Werten. Beide sind ueber je einen Bus 127 und 128 mit einem Schaltelement 129 verbunden, das wiederum in den Bus 104 muendet. Wird die Vorrichtung in Betrieb genommen, so werden Schwellwerte aus dem Speicher 126 ueber den Bus 128 an den Bus 104 und den Bus 149 abgegeben. Die Schwellwerte aus dem Bus 104 werden in bekannter Weise verwendet, waehrend die Schwellwerte aus dem Bus 149 ueber den Sequenzer 147 in den Speicher 125 eingelesen werden. Nach einiger Zeit hat sich dann der Speicher 125 gefuellt und das Schaltelement 129 geht in die gezeigte Stellung ueber. Die ueber die Busse 109, 110 und 111 angelegten Lauflaengen erreichen die Speicher 125 und 126 ueber einen Bus 130, was jeweils die Speicher 125 und 126 befaehigt den betreffenden Schwellwert ueber den Bus 127 oder 128 auszugeben.

Der zweite Zyklus beginnt schon wahrend dem ersten Zyklus, indem der ermittelte Wert der nun bestimmten Lauflaenge LB dazu verwendet wird, um den Schwellwertgenerator 103+106 nochmals den oberen und unteren Schwellwert zu dieser Lauflaenge ueber den Bus 104 auslesen zu lassen. Wurde als Lauflaenge die "4" ermittelt, so sind dies die Schwellwerte "4" und "5". Ueber einen Bus 108 werden diese beiden Schwellwerte Einheiten 131 (Fig. 5) und 132 zugefuehrt. In der Einheit 132 wird der obere Schwellwert um ein (kleinstwertiges) Bit erniedrigt und in der Einheit 131 wird der untere Schwellwert um ein (kleinstwertiges) Bit erhoeht. In der Darstellung gemaess Figur 3, sind somit Lauflaengen 58 und 59 bestimmt. Diese Werte werden ueber je einen Bus 133 und 134 an je einen Vergleicher 135 und 136 abgegeben, wo sie mit dem aktuellen gemessenen Wert der Lauflaenge LB, die ueber einen Bus 105 den Vergleichern 135 und 136 zugefuehrt wird, verglichen werden. Immer dann wenn ein Wert (58, 59) in einem Bus 133 oder 134 mit LB aus dem Bus 105 uebereinstimmt, wird ein Signal ueber die betreffende Leitung 137 oder 138 abgegeben und einem Sequenzer 139 (Fig. 6) zugefuehrt. Zu dieser Zeit liegt im Bus 110 die aktuelle aber bereits definitiv ermittelte Lauflaenge LB am Speicher 141 als Adresse an. Dies bewirkt, dass dort gespeicherte Zahlen ueber einen Bus 142 an den Sequenzer 139 abgegeben wird. Solche Zahlen geben beispielsweise die Differenz der Anzahl bisher gemessener Lauflaengen 50 und 58 (Fig. 3) oder 59 und 60 an. Die eine dieser Zahlen, welche dem unteren Schwellwert zugeordnet ist, wird nun um Eins erhoeht, falls ein Signal in der Leitung 137 anliegt und die andere dieser Zahlen, die dem oberen Schwellwert zugeordnet ist, wird um Eins erniedrigt, wenn ein Signal in der Leitung 138 anliegt. Das bedeutet, dass fuer die Bildung genannter Differenzen, die Lauflaengen 58 und 60 positiv, die Lauflaengen 50 und 59 aber negativ gezaehlt werden. Fuer jede klassierte Lauflaenge sind zwei solcher Speicherplaetze oder fuer jeden Schwellwert 55a, 55b ein Speicherplatz im Speicher 141 vorgesehen. Sammeln sich in diesem Speicherplatz nach einer gewissen, ueber ein Signal in der Leitung 143 zugefuehrten, Zeit zu hohe Zaehlwerte, so liegt der betreffende Schwellwert unguenstig und muss verschoben werden. Ist dieser Vorgang abgeschlossen oder liegt ein neuer Wert fuer eine Lauflaenge im Bus 110 an, so werden die Zahlen aus dem Sequenzer 139 ueber einen Bus 140 wieder in den Speicher 141 zurueckgegeben. Der Speicher 141 ist vorzugsweise als RAM ausgebildet. Liegt im Bus 110 eine andere Lauflaenge an, so laufen entsprechende Vorgaenge fuer andere Schwellwerte ab.

Mit anderen Worten zaehlt der Speicher 141 zusammen mit dem Sequenzer 139 wie haeufig Lauflaengen mit einer gegebenen positiven und negativen Abweichung (oder in einem bestimmten Abstand) vom gueltigen Schwellwert auftreten. Ueberwiegen die Lauflaengen mit positiven oder mit negativen Abweichungen innerhalb einer gewissen vorgegebenen Zeit um ein gewisses Mass, so muss dieser Schwellwert verschoben werden. Ueber eine Leitung 143 wird dem Sequenzer 139 ein Signal uebermittelt, das angibt, wann und wie lange gezaehlt wird. Ueber eine Leitung 144 wird dem Sequenzer 139 mitgeteilt wann er, um einen Schwellwert zu verschieben, entsprechende Signale ueber Leitungen 145 oder 146 abgeben kann. In der einen Leitung 145 bedeutet das Signal, dass der Schwellwert nach oben und in der anderen Leitung 146, dass er nach unten verschoben werden soll. Dies kann beispielsweise in Einheitsschritten erfolgen.

Die Leitungen 145 und 146 muenden in einen Sequenzer 147, der ueber je einen Bus 148 und 149 mit den Speichern 125 und 126 verbunden ist. Der Bus 107 verbindet zusaetzlich den Sequenzer 147 mit dem Speicher 125. Immer wenn eine Lauflaenge LB im Bus 130 anliegt kann ein entsprechender Schwellwert ueber den Bus 127 und 148 in den Sequenzer 147 gelangen und dort um einen Einheitswert vergroessert oder verkleinert werden und anschliessend ueber den Bus 107 wieder in den Speicher 125 zurueckgegeben werden. Die Veraenderung des Schwellwertes findet aber nur dann statt, wenn in den Leitungen 145 oder 146 entsprechende Signale anliegen.

Ueber eine Steuerleitung 150 kann ferner der Betriebszustand des Schaltelementes 129 und des Sequenzers 147 bestimmt werden, der dann entsprechend der Stellung des Schaltelementes 129 mit dem Speicher 125 oder mit dem Speicher 126 zusammenarbeitet.

Das gezeigte Ausfuehrungsbeispiel ist insbesondere fuer die Verarbeitung von digitalen Audiosignalen vorgesehen. Diese fallen mit einer Frequenz von mindestens 44 kHz an. Es ist somit denkbar, fuer Anwendungen im Zusammenhang mit Signalen tieferer Frequenzen gewisse Vereinfachungen vorzunehmen.

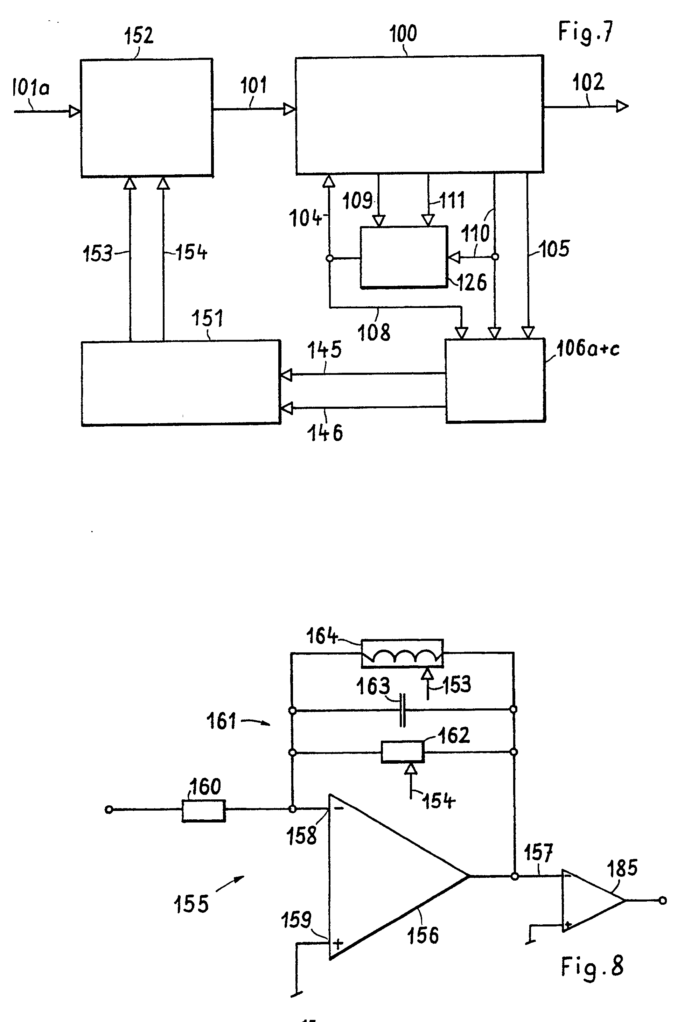

Das erfindungsgemaesse Verfahren eignet sich insbesondere zur Verarbeitung digitaler Signale, die gemaess einem Lauflaengencode codiert sind und welche waehrend der Uebertragung oder Aufzeichnung, beispielsweise auf einem magnetischen Aufzeichnungstraeger, so veraendert worden sind, dass statt den urspruenglich diskreten Lauflaengen nun ueber einen Bereich verteilte Lauflaengen auftreten. Ziel dieser Verarbeitung ist es, diesen ueber einen Bereich verteilten Lauflaengen wieder eine diskrete Lauflaenge zuordnen zu koennen. Dazu werden in einem ersten Schritt die Lauflaengen der Impulse, aus denen ein Eingangssignal besteht, gemessen. Parallel dazu werden auch Schwellwerte vorgegeben, die es gestatten sollen, die Gesamtheit der auftretenden Lauflaengen zu klassieren und einigen Lauflaengenbereichen oder Klassen zuzuordnen. Dabei sollen alle Lauflaengen in der gleichen Klasse urspruenglich, d.h. vor der Verarbeitung, Uebertragung oder Aufzeichnung des Eingangssignales, auch die gleiche Lauflaenge aufgewiesen haben. Die Klassen und somit die Schwellwerte werden mit Hilfe einer statistischen Auswertung der gemessenen Lauflaengen ermittelt. Dann werden laufend auch die Schwellwerte und die gemessenen Lauflaengen so aufeinander abgestimmt, dass die laufende Zuordnung der Lauflaengen zu den Klassen verbessert wird. Dies kann dadurch geschehen, dass die Schwellwerte an die gemessenen Lauflaengen angepasst werden, wie dies in dem eben beschriebenen Verfahren geschieht. Dies kann aber auch dadurch geschehen, dass die zu messenden Lauflaengen vorgaengig an die bestimmten Schwellwerte besser angepasst werden, wie dies anhand des nachfolgend mit den Figuren 7 bis 11 beschriebenen Verfahrens geschieht.

Figur 7 zeigt die bereits bekannte Lauflaengenverarbeitungseinheit 100, der ein Impulsformer 152 vorgeschaltet ist. Dieser erhaelt die ueber eine Leitung 101a eintreffenden Impulse eines Signales und veraendert sie in spaeter beschriebener Weise und gibt sie ueber die Leitung 101 an die Lauflaengenverarbeitungseinheit 100 ab. Darin werden die Impulse auf die bereits beschriebene Weise verarbeitet. Dies geschieht mit Hilfe der Schwellwerte die im Speicher 126 gespeichert sind. Die verarbeiteten Lauflaengen treten ueber den Bus 102 aus. Ueber Busse 105 und 110 ist die Lauflaengenverarbeitungseinheit 100 an eine Statistik-Auswertungseinheit 106a+c und diese wiederum ist ueber Leitungen 145 und 146 an einen Korrektursignalgenerator 151 angeschlossen. Leitungen 153 und 154 sind fuer Korrektursignale aus dem Korrektursignalgenerator 151 an den Impulsformer 152 vorgesehen. Auch hier werden in einem ersten Zyklus die Lauflaengen der Impulse verarbeitet und in einem zweiten Zyklus werden die Korrektursignale fuer die Impulse des Eingangssignales angepasst.

Figur 8 zeigt einen Resonanzverstaerker 155 wie er beispielsweise als Impulsformer 152 verwendet werden kann. Er besteht insbesondere aus einem Operationsverstaerker 156 mit einem Ausgang 157 und Eingaengen 158 und 159. Dem invertierenden Eingang 158 ist ein Eingangswiderstand 160 vorgeschaltet. Der Eingang 159 ist mit der Erde verbunden. Auf den invertierenden Eingang 158 ist eine Rueckkopplung 161 vorgesehen, die aus einem verstellbaren Widerstand 162, einer Kapazitaet 163 und einer verstellbaren Induktivitaet 164 in Parallelschaltung besteht. Die Induktivitaet 164 ist fuer die Verstellung an eine Leitung 153 und der Widerstand zum selben Zweck an eine Leitung 154 angeschlossen. Vorzugsweise ist der Ausgang 157 an einen Komparator 185 angeschlossen, so dass ein digitales Signal abgenommen werden kann.

Der Aufbau und die Funktionsweise der Lauflaengenverarbeitungseinheit 100 entspricht auch fuer diesen Fall demjenigen wie er gemaess Figur 5 beschrieben ist.

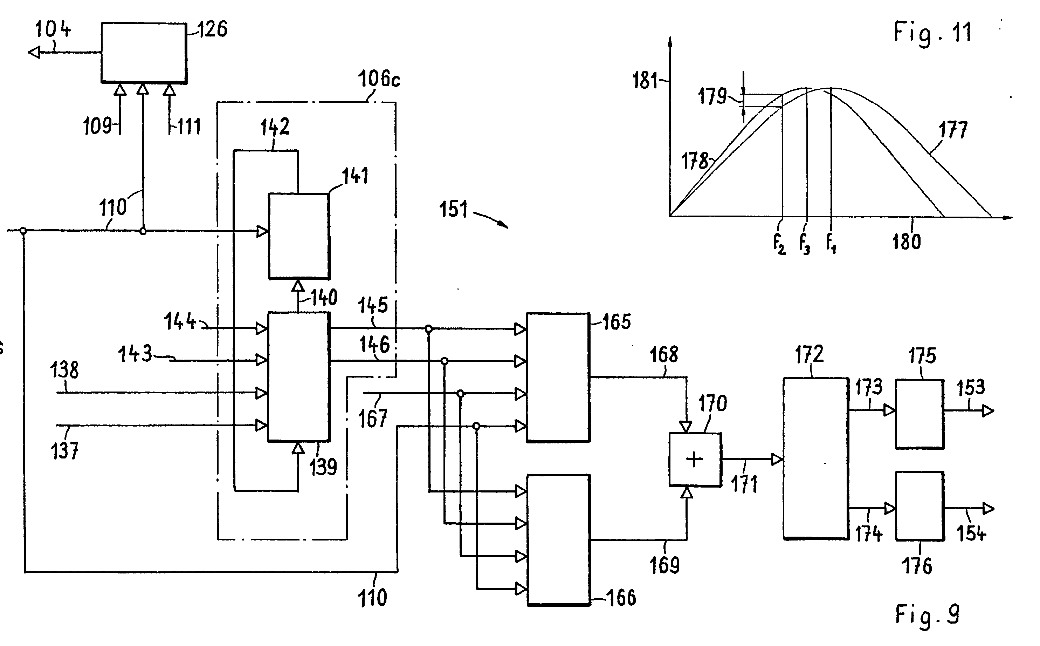

Figur 9 zeigt die Ausbildung des Schwellwertgenerators 103+106 wie er fuer diesen Fall ausgebildet ist. Ueber den Bus 110 wird die aktuelle Lauflaenge LB dem Speicher 126 zugefuehrt. Ueber weitere Busse 109 und 111 wird die vorausgehende und die nachfolgende Lauflaenge dem Speicher 126 ebenfalls zugefuehrt. Dies erlaubt dem Speicher 126 einen Schwellwert ueber den Bus 104 an den Vergleicher 120 abzugeben. Dies wiederholt sich so oft, bis der Hypothesengenerator 121 ein Resultat abgibt. Der letzte Schwellwert und der um Eins erniedrigte folgende Schwellwert, der nur fuer die Korrektur der Impulse eine Bedeutung hat, werden in bekannter Weise dem Teil 106a der Auswertungseinheit 106 zugefuehrt und darin verarbeitet. Der Bus 137 und 138 gibt dementsprechend Signale an den Sequenzer 139 ab, der zusammen mit dem Speicher 141 den Teil 106c bildet. In bekannter Weise wird im Sequenzer 139 und im Speicher 141 zusammen ermittelt, ob die Schwellwerte richtig oder unguenstig liegen. Falls die Schwellwerte unguenstig liegen, gibt der Sequenzer 139 ueber die Leitung 145 ein Signal ab, das bedeutet ob der Schwellwert nach oben oder nach unten zu verschieben ist. Ueber die Leitung 146 wird ein Befehl erteilt ob und wann die Verschiebung des Schwellwertes erwuenscht ist. Diese Signale werden einem Zaehler 165 und einem Zaehler 166 zugefuehrt. Beide Zaehler sind auch an den Bus 110 angeschlossen und erhalten zudem ueber eine Leitung 167 ein Zeitsignal. Fuer die Beurteilung der Lage der Schwellwerte werden einfachheitshalber nur ausgewaehlte Lauflaengen beobachtet. Deshalb zaehlt der Zaehler 165 beispielsweise nur dann die Befehle zur Verschiebung eines Schwellwertes aus der Leitung 145 und 146, wenn eine Lauflaenge mit dem Wert "3" im Bus 110 anliegt. Der Zaehler 166 tut dasselbe fuer Lauflaengen mit dem Wert "4". Beide Zaehler 165 und 166 zaehlen aber nur solange das Zeitsignal aus der Leitung 167 dies zulaesst. Dann startet dieses Zeitsignal die Zaehler wieder. Die Zaehlwerte aus den Zaehlern 165 und 166 werden ueber Leitungen 168 und 169 einer Additionsschaltung 170 zugefuehrt und dort addiert. Das Resultat wird ueber eine Leitung 171 einem Speicher 172 als Adresse eingegeben. Der Speicher 172 enthaelt Korrektursignale, die ueber Leitungen 173 und 174 an Register 175 und 176 abgegeben werden. Diese geben die Korrektursignale immer dann ab, wenn eine Zaehlperiode zu Ende ist. Die Korrektursignale koennen beispielsweise vorausgehend experimentell ermittelt und dann in den Speicher 172 eingelesen werden.

Mit den Korrektursignalen, die ueber die Leitungen 153 und 154 aus den Registern 175 und 176 entnommen werden koennen, lassen sich die verstellbaren Widerstaende 162 und Induktivitaeten 164 eines Resonanzverstaerkers 155 verstellen. Damit wird die Form der Impulse im Eingangssignal anstatt der Schwellwerte veraendert.

Figur 11 zeigt den Frequenzgang eines Resonanzverstaerkers, beispielsweise des Resonanzverstaerkers 155. Dabei ist laengs der horizontalen Achse 180 die Frequenz eines Signales und laengs der vertikalen Achse 181 die Verstaerkung aufgetragen. Je nach Einstellung des Widerstandes 162 und der Induktivitaet 164 ergibt sich eine Kurve 177 mit einer maximalen Verstaerkung fuer Signale mit einer Frequenz f1. Besteht ein Signal beispielsweise nur aus gleich langen Impulsen, so ist seine Frequenz konstant und hat beispielsweise den Wert f2. Dabei kann aus der Kurve 177 ein Wert fuer die Verstaerkung dieses Signales entnommen werden. Durch Veraendern der Verstaerkung fuer dieses Signal, kann die Form der Impulse und auch der Ort der Nulldurchgaenge der Flanken dieser Impulse veraendert werden. Dies ist beispielsweise erwuenscht, um die Signale und deren Lauflaengen besser an die vorhandenen Schwellwerte anzupassen. Um also die Verstaerkung bei einer bestimmten Frequenz zu veraendern, wird im Resonanzverstaerker der Widerstand und die Induktivitaet veraendert. Dies ergibt in der Figur 11 beispielsweise eine andere Kurve 178 mit maximaler Verstaerkung bei einer Frequenz f3. Fuer die Frequenz f2 ergibt sich eine um den Betrag 179 erhoehte Verstaerkung. Diese wird somit durch die Korrektursignale in den Leitungen 153 und 154 (Figur 9) bewirkt.

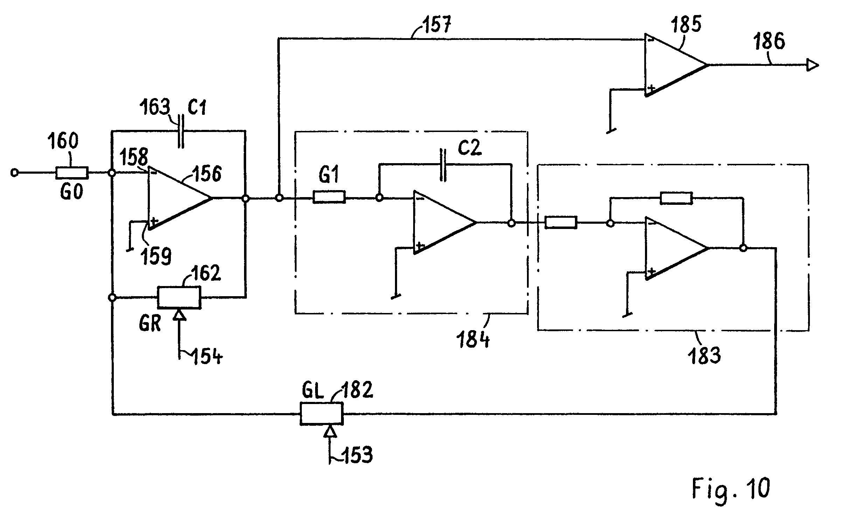

Eine weitere Moeglichkeit fuer den Aufbau eines Resonanzverstaerkers ist in der Figur 10 gezeigt. Neben den bereits aus der Figur 8 bekannten Elementen, ist in der Ruekkopplung die verstellbare Induktivitaet 164 durch eine Serieschaltung eines verstellbaren Widerstandes 182, eines Umkehrverstaerkers 183 und eines Integrierers 184 ersetzt. Der Ausgang 157 weist auch noch einen Komparator 185 auf. Bei diesem Resonanzverstaerker kann die Resonanzfrequenz durch Verstellen der beiden Widerstaende 162 und 182 veraendert werden. Am Ausgang 186 des Komparators 185 ist dann ein digitales Signal erhaeltlich. Fuer die Schaltung gemaess Figur 10 gilt die Laplace-Uebertragungsfunktion A (p) mit

$$A(p) = \frac{[(G0 \cdot C2)/(G2 \cdot G1)] \cdot p}{1 + p \cdot \left[\dfrac{GR \ C2}{G1 \ G2}\right] + p^2 \left[\dfrac{C1 \ C2}{G2 \ G1}\right]}$$

der Qualitaetsfaktor Q mit

$$Q = \frac{1}{GR} \sqrt{\frac{C1 \cdot G1 \cdot G2}{C2}} = \text{konstant} \quad \text{und}$$

der variablen Frequenz $f = \dfrac{1}{2P \ i} \cdot \sqrt{GL} \cdot \sqrt{\dfrac{G1}{C1 \cdot C2}}$ wobei

p der Laplaceoperator und G Leitwerte sind.

**Ansprüche**

1. Verfahren zur Verarbeitung von Impulsen (2 bis 6) eines Signales (1), das durch vorausgehende Uebertragung verzerrt ist, wobei Lauflaengen (16, 17, 18) der einzelnen Impulse (3, 4, 5) gemessen werden, mehrere Schwellwerte (29 bis 35) fuer die Lauflaengen vorgegeben werden, wobei die Schwellwerte Lauflaengenbereiche definieren, die Klassen (61 bis 66) fuer die gemessenen Lauflaengen bilden und die Klassen die urspruengliche Lauflaenge der unverzerrten Impulse angeben, dadurch gekennzeichnet, dass diese gemessenen Lauflaengen laufend zur Verbesserung der Anpassung der durch die Schwellwerte definierten Lauflaengenbereiche an eine Haeufigkeitsverteilung der gemessenen Lauflaengen verwendet werden.

2. Verfahren gemaess Anspruch 1, dadurch gekennzeichnet, dass zur Verbesserung der Anpassung periodisch Schwellwerte (29 bis 35) durch neue Schwellwerte (55a, b) ersetzt werden, die aufgrund gemessener Lauflaengen aus zwei Klassen ermittelt werden.

3. Verfahren gemaess Anspruch 2, dadurch gekennzeichnet, dass ein neuer Schwellwert (55a, b) bei einer solchen Lauflaenge liegt, von der ein positiver Abstand (56) und ein negativer Abstand (57) zugerechnet werden kann, bei denen Lauflaengen (59, 60) mit gleicher Haeufigkeit auftreten.

4. Verfahren gemaess Anspruch 1, dadurch gekennzeichnet, dass fuer die Ermittlung der urspruenglichen Lauflaenge eines Impulses (4) waehlbarer Laenge, die benachbarten Impulse (3 und 5) konstant gehalten werden.

5. Verfahren gemaess Anspruch 1, dadurch gekennzeichnet, dass die Verbesserung der Anpassung der Lauflaengenbereiche an die gemessenen Lauflaengen ausgehend von der gemessenen Haeufigkeit des Auftretens von bestimmten Lauflaengen (59, 60, 51, 52) innerhalb mindestens einer Klasse erfolgt.

6. Verfahren gemaess Anspruch 1, dadurch gekennzeichnet, dass zur Verbesserung der Anpassung der Lauflaengenbereiche an die gemessenen Lauflaengen, die Impulse des Signales (1) und deren Lauflaengen aufgrund eines Korrektursignales veraendert werden, zu dessen Emittlung beidseitig eines Schwellwertes (55a) die Haeufigkeit bestimmter Lauflaengen (50, 58) gezaehlt wird.

7. Verfahren gemaess Anspruch 1, dadurch gekennzeichnet, dass in den Klassen (65, 66) je diejenige Lauflaenge (51, 52) ermittelt wird, die am haeufigsten gemessen wird und dass neue Schwellwerte (53) aus den haeufigsten beiden Lauflaengen (51 und 52) aus zwei aufeinanderfolgende Klassen (65, 66) ermittelt werden, die durch drei aufeinanderflogende Schwellwerte (33, 34, 35) abgegrenzt werden.

8. Vorrichtung zur Verarbeitung von Impulsen eines Signales, das durch vorausgehende Uebertragung verzerrt ist, mit einer Einkeit zum Messen von Lauflängen der Impulse und Verarbeitung der gemessenen Lauflängen durch Einteilung der gemessenen Lauflängen in vorgegebene durch Schwellwerte definierte Lauflängen der unverzerrten Impulse angeben, gekennzeichnet durch eine Einheit zur laufenden Anpassung von den durch Schwellwerte definierten Lauflaengenbereichen an eine Haeufigkeitsverteilung der gemessenen Lauflaengen.

9. Vorrichtung gemaess Anspruch 8, gekennzeichnet durch einen Speicher (126) fuer Schwellwerte.

10. Vorrichtung gemaess Anspruch 8, dadurch gekennzeichnet, dass der Einheit (100, 112) zum Messen der Lauflaengen ein Impulsformer (152) vorgeschaltet ist, der durch korrektursignale ansteuerbar ist.

## Claims

1. Method of processing a signal (1) containing pulses (2 to 6) which have been distorted by a preceding signal transfer operation, whereas the running lengths (16, 17, 18) of individual pulses (3, 4, 5) are measured, whereas a number of threshold values (29 to 35) associated with predetermined values of the running lengths are presetted and whereas said threshold values define classes (61 to 66) of running lengths intended to contain running lengths of pulses which originally had the same running lengths, characterised in that said measured running lengths are utilised for continuously improving the adaptation of the classes defined by the threshold values to a frequency distribution of the measured running lengths.

2. Method according to claim 1, characterised in that improving the adaptation is done by periodically replacing said preset threshold values (29 to 35) by revised threshold values (55a, b) based on measured running lengths associated with two classes.

3. Method according to claim 2, characterised in that each one of said revised threshold values (55a, b) is determined as a threshold value relative to which running lengths (59, 60) of substantially equal frequency of occurrence appear at predetermined spacings (56, 57) from such revised threshold value in a direction to greater running lenghts as well as in a direction to smaller running lengths.

4. Method according to claim 1, characterised in that determining the original running length of a predetermined individual pulse (4) is done by maintaining constant the running lengths of pulses (3 and 5) adjacent to said predetermined individual pulse.

5. Method according to claim 1, characterised in that said improving the adaptation of the classes to measured running lengths is started based on the measured frequency of occurrence of predetermined running lengths (59, 60, 51, 52) within at least one class.

6. Method according to claim 1, characterised in that pulses of said signal (1) are altered based on a correction signal for improving the adaptation of the classes to measured running lengths and in that said correction signal is generated based on counting the frequency of occurrence of predetermined running lengths (50, 58) measured on both sides of a predetermined threshold value (55a).

7. Method according to claim 1, characterised in that the running length (51, 52) which is measured at the highest frequency of occurrence is determined for the classes (65, 66), and in that revised threshold values (53) are determined by utilising the most frequently occurring running lengths (51 and 52) of two consecutive ones of different classes (65, 66), which are bounded by three associated ones of said threshold values (33, 34, 35).

8. Apparatus for processing a signal (1) containing pulses (2 to 6) which have been distorted by a preceding signal transfer operation, comprising a unit (100, 112) for measuring the running length of the pulses and for processing the measured running lengths by classifying the measured running lengths into classes defined by preset threshold values which classes are intended to contain running lengths of pulses which originally had the same running length, characterised by a unit for adapting the classes defined by the threshold values to a distribution of the frequency of occurrence of measured running lengths.

9. Apparatus according to claim 8, characterised by a storage unit (126) for storing threshold values.

10. Apparatus according to claim 8, characterised in that a pulse former (152) controllable by correction signals is series connected to said unit for measuring running lengths.

## Revendications

1. Méthode pour le traitement d'un signal (1) composé d'impulsions (2 à 6) distordues lors d'une transmission précédente du signal, où la longueur (16, 17, 18) de chaque impulsion (3, 4, 5) est mesurée, où plusieurs seuils (29 à 35) sont prévus qui se rapportent à ces longueurs, où ces seuils délimitent des plages qui correspondent à des classes (61 à 66) pour les longueurs d'impulsions mesurées et où ces classes représentent la longueur originale des impulsions sans distorsions, caractérisée en ce que les longueurs mesurées sont utilisées à améliorer l'adaptation des plages définies par les seuils à une distribution des longueurs mesurées.

2. Méthode selon la revendication 1, caractérisée en ce que des seuils (29 à 35) sont périodiquement remplacées par de nouveaux seuils (55a, b) qui sont déterminés à partir de longueurs mesurées qui appartiennent à deux classes, afin d'améliorer l'adaptation.

3. Méthode selon la revendication 2, caractérisée en ce qu'un nouveau seuil (55a, b) correspond à telle longueur qui est à une distance positive (56) et à une distance négative (57) de deux longueurs (59, 60) qui sont comptées le même nombre de fois.

4. Méthode selon la revendication 1, caractérisée en ce que les longueurs des impulsions (3 et 5) qui sont voisines d'une impulsion (4) dont la longueur originale doit être trouvée, sont maintenues constantes.

5. Méthode selon la revendication 1, caractérisée en ce que l'adaptation des plages aux longueurs mesurées est améliorée partant de la fréquence où certaines longueurs (59, 60, 51, 52) sont comptées dans au moins une classe.

6. Méthode selon la revendication 1, caractérisée en ce que l'adaptation des plages aux longueurs mesurées est améliorée en modifiant les impulsions du signal (1) et leur longueur avec l'aide d'un signal de correction qui est déterminé en fonction du nombre de longueurs prédéterminées (50, 58) qui sont comptées des deux côtés d'un seuil (55a).

7. Méthode selon la revendication 1, caractérisée en ce que dans chaque classe (65, 66) la longueur (51, 52) qui apparaît le plus souvent est déterminée et que de nouveaux seuils (53) sont déterminés à partir des longueurs (51 et 52) les plus souvent mesurées dans deux classes (65, 66) qui se succèdent et qui sont délimitées par trois seuils (33, 34, 35) successifs.

8. Dispositif pour le traitement des impulsions d'un signal distordues lors d'une transmission précédente, pourvu d'une unité pour mesurer la longueur des impulsions et pour traiter les longueurs mesurées en les classant en des classes prédéterminées et définies par des seuils qui indiquent la longueur originale des impulsions non-distordues, caractérisé par une unité pour adapter les classes définies par des seuils à une distribution des longueurs mesurées.

9. Dispositif selon la revendication 8, caractérisé par une mémoire (126) pour des seuils.

10. Dispositif selon la revendication 8, caractérisé par un correcteur d'impulsions (152) commandé par des signaux de correction relié à l'entrée de l'unité (100, 112) pour

Fig.1a

Fig.1b

Fig.1c

Fig.1d

Fig.2a

Fig.2b

Fig.2c

Fig. 3

Fig. 4

Fig.5

Fig.6

Fig.7

Fig.8

Fig. 11

Fig. 9

EP 0 253 215 B1

Fig. 10

EP 0 253 215 B1